# EUROPEAN PATENT APPLICATION

(11) **EP 4 506 946 A1**
(43) Date of publication of application: **12.02.2025**
(21) Application number: 23795520.8
(22) Date of filing: 27.04.2023
(51) Int. Cl.: G11C 16/14

(54) **STORAGE CHIP, STORAGE APPARATUS AND ELECTRONIC DEVICE**

(30) Priority: 28.04.2022 CN 202210469527
(71) Applicant: Huawei Technologies Co., Ltd., Shenzhen, Guangdong 518129 (CN)
(72) Inventor: LI, Xiang, Shenzhen, Guangdong 518129 (CN); WU, Quantan, Shenzhen, Guangdong 518129 (CN)
(74) Representative: MERH-IP Matias Erny Reichl Hoffmann Patentanwälte PartG mbB
(86) International application number: PCT/CN2023/091050
(87) International publication number: WO 2023/208088

(57) **Abstract**

Embodiments of this application disclose a storage chip, a storage apparatus, and an electronic device, which belong to the field of electronic technologies. The storage chip includes a plurality of first storage units, and each first storage unit includes a first storage medium, a first selector, and a first electrode. The first storage medium is in contact with a first surface of the first electrode, a first surface of the first selector is in contact with a second surface of the first electrode, and the first surface and the second surface that are of the first electrode are two opposite surfaces. A first cross-sectional area corresponding to a maximum cross section of the first selector perpendicular to a current direction is greater than a second cross-sectional area corresponding to a minimum cross section of the first storage medium perpendicular to the current direction. This application can increase a current density in a storage medium, to enable storage media and selectors of more materials to be used in storage chips.

## Description

This application claims priority to Chinese Patent Application No. 202210469527.3, filed with the China National Intellectual Property Administration on April 28, 2022 and entitled "STORAGE CHIP, STORAGE APPARATUS, AND ELECTRONIC DEVICE", which is incorporated herein by reference in its entirety.

### TECHNICAL FIELD

This application relates to the field of electronic technologies, and in particular, to a storage chip, a storage apparatus, and an electronic device.

### BACKGROUND

A resistive random-access memory is a device that can store data by using different resistance values, for example, the resistive random-access memory with a high resistance is used to store "1" and the resistive random-access memory with a low resistance is used to store "0".

In a storage chip in which the resistive random-access memory is used to store data, each resistive random-access memory may be connected to one selector to form one storage unit. Different storage units may be coupled to different word lines and bit lines respectively. By applying a voltage to a bit line and a word line, a selector coupled to the bit line and the word line can be selected and switched on, so that an operation such as read, write, or erase can be performed on a corresponding resistive random-access memory unit.

To perform the operation such as read, write, or erase on the resistive random-access memory, a current density in the resistive random-access memory unit needs to reach a corresponding current density threshold. However, whether the current density in the resistive random-access memory can reach the current density threshold at a given voltage is affected by a material of the resistive random-access memory and a material of the selector. This limits use of resistive random-access memories and selectors of many materials in storage chips.

### SUMMARY

This application provides a storage chip, a storage apparatus, and an electronic device, to enable storage media and selectors of more materials to be used in storage chips.

According to a first aspect, this application provides a storage chip, where the storage chip includes a plurality of first storage units 1, and each first storage unit 1 includes a first storage medium, a first selector, and a first electrode. The first storage medium is in contact with a first surface of the first electrode, a first surface of the first selector is in contact with a second surface of the first electrode, and the first surface and the second surface that are of the first electrode are two opposite surfaces. A first cross-sectional area corresponding to a maximum cross section of the first selector perpendicular to a current direction is greater than a second cross-sectional area corresponding to a minimum cross section of the first storage medium perpendicular to the current direction.

In a conventional technology, to increase a data storage amount of the storage chip, the storage medium is usually processed to a minimum size that can be achieved by a current processing technology, and for ease of processing, the selector may be processed to a same size with the storage medium. In solutions shown in this application, an area of the maximum cross section of the first selector perpendicular to the current direction is set to be greater than an area of the minimum cross section of the first storage medium perpendicular to the current direction. Compared with the conventional technology, this increases a cross-sectional area of the first selector perpendicular to the current direction, so that more current can flow into the first selector. In addition, because the first selector and the first storage medium are connected in series, current flowing into the first storage medium is also increased, and a current density in the first storage medium may be further increased.

It can be learned that, in the storage chip provided in this application, the current density in the storage medium can be increased by changing a size of the selector, which enables some selectors and storage media that originally cannot reach a corresponding current density threshold to reach the corresponding current density threshold, so that selectors and storage media of more materials can be used in storage chips.

In a possible implementation, the first storage unit further includes a second electrode, the second electrode is in contact with a second surface of the first selector, and the maximum cross section of the first selector perpendicular to the current direction is the second surface of the first selector. In this way, through setting the maximum cross section of the first selector perpendicular to the current direction as a contact surface between the first selector and the second electrode, the larger contact surface can support more current flowing from the second electrode into the first selector, thereby increasing the current in the first selector and the first storage medium and increasing the current density in the first storage medium.

In a possible implementation, a third cross-sectional area corresponding to a minimum cross section of the first selector perpendicular to the current direction is greater than or equal to the second cross-sectional area.

In the solutions shown in this application, through setting the third cross-sectional area corresponding to the minimum cross section of the first selector perpendicular to the current direction to be greater than or equal to the second cross-sectional area corresponding to the minimum cross section of the first storage medium perpendicular to the current direction, an average cross-sectional area of cross sections of the first selector perpendicular to the current direction is greater than an average cross-sectional area of cross sections of the first storage medium perpendicular to the current direction. In this way, compared with the conventional technology, this increases the cross-sectional area of the first selector perpendicular to the current direction, enables more current to flow into the first selector, and increases the current density in the first storage medium.

In a possible implementation, the minimum cross section of the first selector perpendicular to the current direction is the first surface of the first selector. In this way, when the minimum cross section of the first selector perpendicular to the current direction is the first surface of the first selector, and the maximum cross section of the first selector perpendicular to the current direction is the second surface of the first selector, the first selector is of a structure in which one end is large and the other end is small. This facilitates processing of the first selector and improves processing efficiency of the storage chip.

In a possible implementation, the first selector is a hexahedron, and the hexahedron includes two parallel trapezoidal surfaces and two parallel rectangular surfaces, where the first surface and the second surface that are of the first selector are respectively the two parallel rectangular surfaces of the hexahedron.

In a possible implementation, the first selector is a trapezoidal body, and the first surface and the second surface that are of the first selector are respectively two parallel rectangular surfaces of the trapezoidal body.

In a possible implementation, the plurality of first storage units form a three-dimensional storage array, and the three-dimensional storage array includes multiple layers of storage arrays. In at least one layer of storage array, first selectors of the first storage units located in a same row or column are integrally formed.

In the solutions shown in this application, the storage chip may be a three-dimensional storage chip, and the first storage units may form the three-dimensional storage array in the three-dimensional storage chip. In any layer of the three-dimensional storage array, the first selectors of the first storage units located in the same row or column are integrally formed. In other words, the plurality of first storage units located in the same row or column may share one selector with a large size. In this way, after an operation such as read or write is performed in one storage unit, heat in the storage unit can be quickly transferred out through the selector with the large size. This is conducive to heat dissipation of the storage chip and improvement in performance of the storage chip.

In a possible implementation, the plurality of first storage units form a three-dimensional storage array, and the three-dimensional storage array includes multiple layers of storage arrays. For two adjacent layers of the multiple layers of storage arrays, an average cross-sectional area of cross sections of a first selector perpendicular to the current direction at one layer of storage array is greater than an average cross-sectional area of cross sections of a first selector perpendicular to the current direction at the other layer of storage array.

Because the first storage medium is mostly made of a semiconductor material, when current directions in some semiconductor materials are different, the semiconductor materials may have temperature rise or temperature fall characteristics respectively. When a temperature changes, a current density required for performing an operation such as read, write, or erase on the first storage medium changes. In the three-dimensional storage chip, because a current direction between a bit line and a word line is determined, and storage units at two adjacent layers in the three-dimensional storage chip share a same group of bit lines or word lines, current directions corresponding to the storage units at the two adjacent layers are opposite. In this case, in the storage units at the two adjacent layers, a temperature of a phase change memory at one layer is increased due to the current direction, and a required current density is decreased; and a temperature of a phase change memory at the other layer is decreased due to the current direction, and a required current density is increased.

In the solutions shown in this application, a cross section of the first selector perpendicular to the current direction at the layer whose temperature is decreased may be set to be larger, to enable more current to flow into the first storage unit at this layer, so that the first storage medium can have a larger current density. This can resolve a problem caused by a temperature decrease, to provide the increased current density required for performing the operation such as read, write, or erase on the first storage medium.

In a possible implementation, the storage chip further includes a plurality of second storage units, the plurality of first storage units and the plurality of second storage units form a three-dimensional storage array, and the three-dimensional storage array includes multiple layers of storage arrays. Each second storage unit includes a second storage medium, a second selector, and a third electrode. The second storage medium is in contact with a first surface of the third electrode, the second selector is in contact with a second surface of the third electrode, and the first surface and the second surface that are of the first electrode are two opposite surfaces. Any cross section of the second selector perpendicular to the current direction is the same as any cross section of the second storage medium perpendicular to the current direction. The plurality of first storage units and the plurality of second storage units are respectively located in two adjacent layers of the multiple layers of storage arrays.

In the solutions shown in this application, a storage array formed by the first storage units and a storage array formed by the second storage units are two adjacent storage arrays, and each storage array formed by the first storage units may be a storage array in which the temperature of the storage medium is decreased due to the current direction. In this way, in the multiple layers of storage arrays, there are more current flowing into the first storage unit, so that the first storage medium has a larger current density. This can resolve the problem caused by the temperature decrease, to provide the increased current density required for performing the operation such as read, write, or erase on the first storage medium.

In a possible implementation, the first storage medium is a resistive random-access memory.

According to a second aspect, a storage apparatus is provided, where the storage apparatus includes a peripheral circuit and at least one storage chip provided in any one of the first aspect or the optional manners of the first aspect, and the peripheral circuit is configured to read data from or write data into the storage chip.

According to a third aspect, an electronic device is provided, where the electronic device includes a processor and the storage apparatus provided in the second aspect, and the processor is configured to read data from or write data into the storage apparatus.

Beneficial effects of the technical solutions provided in embodiments of this application are as follows.

In the technical solutions provided in embodiments of this application, the area of the maximum cross section of the first selector perpendicular to the current direction is set to be greater than the area of the minimum cross section of the first storage medium perpendicular to the current direction. Compared with the solution in the conventional technology that the cross section of the first selector perpendicular to the current direction is the same as that of the first storage medium perpendicular to the current direction, this increases the cross-sectional area of the first selector perpendicular to the current direction, so that more current can flow into the first selector. In addition, because the first selector and the first storage medium are connected in series, the current flowing into the first storage medium is also increased, and the current density in the first storage medium may be further increased. It can be learned that, in the storage chip provided in this application, the current density in the storage medium can be increased. For example, the storage medium may be a resistive random-access memory. In this way, some resistive random-access memories and selectors that originally cannot reach a corresponding current density when used in combination can reach a corresponding current density. This enables resistive random-access memories and selectors of more materials to be used in storage chips, and is conducive to improvement in performance of the storage chip.

### BRIEF DESCRIPTION OF DRAWINGS

FIG. 1 is a schematic diagram of a structure of a conventional storage chip;
FIG. 2 is a schematic diagram of a structure of a storage chip according to an embodiment of this application;
FIG. 3 is a schematic diagram of a structure of a storage chip according to an embodiment of this application;
FIG. 4 is a schematic diagram of a structure of a storage chip according to an embodiment of this application;
FIG. 5 is a schematic diagram of a structure of a storage chip according to an embodiment of this application;
FIG. 6 is a schematic diagram of a structure of a storage chip according to an embodiment of this application;
FIG. 7 is a schematic diagram of a structure of a storage chip according to an embodiment of this application;
FIG. 8 is a schematic diagram of a structure of a storage apparatus according to an embodiment of this application; and
FIG. 9 is a schematic diagram of a structure of an electronic device according to an embodiment of this application.

### Reference numerals

1. First storage unit; 11. first storage medium; 12. first selector; 13. first electrode; 14. second electrode; 15. word line; 16. bit line;
2. second storage unit; 21. second storage medium; 22. first selector; 23. third electrode;
800. storage chip;
810. storage chip; 811. storage array;
820. peripheral circuit; 821. row decoder; 822. column decoder; 823. sense amplifier; 824. read/write driver circuitry; 825. digital controller; 826. data buffer; 827. input/output interface;
900. electronic device 900;
910. processor; and 920. storage apparatus.

### DESCRIPTION OF EMBODIMENTS

To make the objectives, technical solutions, and advantages of this application clearer, the following further describes the implementations of this application in detail with reference to the accompanying drawings.

The following explains and describes some terms and concepts in embodiments of this application.

Storage chip: It includes one or more layers of storage arrays, one layer of storage array includes n*m storage units, and the n*m storage units are respectively coupled to n word lines and m bit lines.

Storage unit: It may include a storage medium and a selector. Through applying a voltage to a word line and a bit line that are coupled to the storage unit, the selector in the storage unit is switched on, so that an operation such as read or write is performed on the storage medium in the storage unit.

Storage medium: It is a component that stores data such as "0" and "1" by changing physical features.

Resistive random-access memory: It is a storage medium that can store data by using different resistance values, for example, the resistive random-access memory with a high resistance is used to store "1", and the resistive random-access memory with a low resistance is used to store "0".

Phase change memory (phase change memory, PCM): It is a non-volatile memory based on a chalcogenide phase change material, which belongs to a resistive random-access memory. Under a thermal effect, the phase change memory can perform conversion under different resistance values, and data "0" and "1" can be stored by using a difference of 10 to 10000 times of resistance values between a high resistance state and a low resistance state.

Selector: It is a switching device that has different turn-on states under different voltages, which can be configured to suppress impact of leakage current in a storage chip on a storage medium.

Word line (Word Line, WL): One piece of word line is connected to one row of storage units at one layer of storage array, and a voltage different from that applied to other word lines is applied to a selected word line, so that a row of storage units can be selected from the storage array.

Bit line (Bit Line, BL): One piece of bit line is connected to one column of storage units at one layer of storage array, and a voltage different from that applied to other word lines is applied to a selected word line, so that a row of storage units can be selected from the storage array.

Ovonic threshold switch (Ovonic Threshold Switch, OTS): It is a volatile selector based on a chalcogenide material. The ovonic threshold switch presents a high resistance state under a low voltage to suppress leakage current, and presents a low resistance state under a high programming voltage to provide sufficient current for a read or write operation. The ovonic threshold switch can be used as a selector to be connected in series with a non-volatile phase change memory, to form a storage unit for implementing high-density non-volatile storage.

Current density: It is current per unit cross-sectional area. The calculation formula is J=I/S, where I is the current, J is the current density, and S is the cross-sectional area.

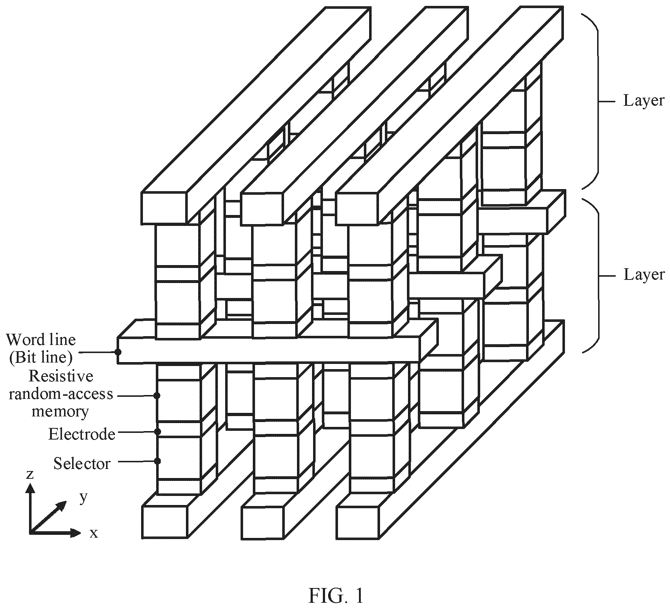

FIG. 1 is a schematic diagram of a structure of a conventional storage chip. The storage chip is a three-dimensional storage chip. The storage chip includes multiple layers of storage arrays, and the multiple layers of storage arrays may be stacked in a z-axis direction (where one layer of storage array may briefly be referred to as a layer, and only two layers are schematically shown in FIG. 1). Storage units at each layer of storage array may be coupled to different bit lines and word lines. For any storage unit, a specific voltage may be applied to a word line and a bit line that are coupled to the storage unit, to select and switch on a selector in the storage unit, so that an operation such as read, write, or erase is performed on a storage medium in the storage unit.

The storage medium in the storage unit may be a resistive random-access memory, and an electrical connection may be established between the resistive random-access memory and the selector in the storage unit through one electrode. The resistive random-access memory, the selector, and the electrode may be a cuboid, and areas of cross sections of the resistive random-access memory, the selector, and the electrode perpendicular to a current direction are the same, where the current direction is a direction corresponding to current flowing through the storage unit, and is parallel to a z-axis direction. The storage unit is electrically connected to the word line and the bit line respectively through two electrodes. The two electrodes may also be cuboids, and areas of cross sections of the two electrodes perpendicular to the current direction are the same as an area of a cross section of the storage unit perpendicular to the current direction. The word line or the bit line connected to the storage unit may also be a cuboid, and a width of the word line or the bit line may be the same as a width corresponding to an electrode electrically connected to the word line or the bit line. The word line, the bit line, and the electrode are made of conductive materials, such as conductive metals.

To perform the operation such as read, write, or erase on the storage medium (for example, a resistive random-access memory) in the storage unit, a current density in the resistive random-access memory needs to reach a corresponding current density threshold. In other words, a current value in the resistive random-access memory needs to reach a corresponding current threshold, that is, the current in the resistive random-access memory and the selector needs to reach the corresponding current threshold within a given voltage range. In this case, use of resistive random-access memories and selectors of multiple materials in variable resistance storage apparatuses is limited, and improvement in performance of the storage chip is limited.

In a storage chip provided in embodiments of this application, a current density in a storage medium can be increased without changing a material of the storage medium and a material of a selector. This enables storage media and selectors of some materials that originally do not satisfy a matching condition to satisfy the matching condition. The matching condition means that, within a given voltage range, in a storage unit formed by the storage medium and the selector, a current density of a resistive random-access memory reaches a corresponding current density threshold.

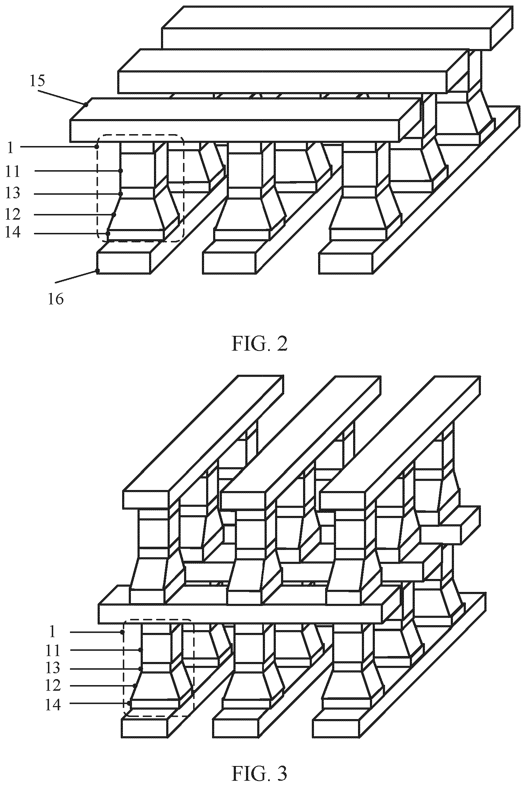

FIG. 2 is a schematic diagram of a structure of a storage chip according to an embodiment of this application. As shown in FIG. 2, the storage chip includes a plurality of first storage units 1, and each first storage unit 1 includes a first storage medium 11, a first selector 12, and a first electrode 13.

Refer to FIG. 2. In the first storage unit 1, the first storage medium 11 is in contact with a first surface of the first electrode 13, a first surface of the first selector 12 is in contact with a second surface of the first electrode 13, and the first surface and the second surface that are of the first electrode are two opposite surfaces. A first cross-sectional area corresponding to a maximum cross section of the first selector 12 perpendicular to a current direction is greater than a second cross-sectional area corresponding to a minimum cross section of the first storage medium 11 perpendicular to the current direction. The first storage medium 11 may be a resistive random-access memory, and the first selector 12 may be an ovonic threshold switch.

In one case, shapes and areas of cross sections of the first storage medium 11 perpendicular to the current direction are the same. For example, the first storage medium 11 is a cuboid. In other words, the minimum cross section of the first storage medium 11 perpendicular to the current direction (or referred to as the minimum cross section of the first storage medium 11 subsequently) is any cross section of the first storage medium 11 perpendicular to the current direction.

In this case, the first cross-sectional area corresponding to the maximum cross section of the first selector 12 perpendicular to the current direction (or referred to as the maximum cross section of the first selector 12 subsequently) is greater than the second cross-sectional area corresponding to the minimum cross section of the first storage medium 11, which indicates that the maximum cross section of the first selector 12 is greater than all cross sections of the first storage medium 11. In this way, under a voltage provided by a bit line 15 and a word line 16 that are coupled to the first storage unit 1 shown in FIG. 2, because a cross section of the first selector 12 perpendicular to the current direction becomes larger, current flowing into the first selector 12 is increased. Because the first storage medium 11 and the first selector 12 are connected in series, current flowing into the first storage medium 11 is also increased. In addition, because a cross-sectional area of a cross section of the first storage medium 11 perpendicular to the current direction does not change, a current density in the first storage medium 11 is increased.

In another case, possibly, for some reasons, an area of a part of the cross section of the first storage medium 11 perpendicular to the current direction is increased. In other words, there may be cross sections with different areas in the cross sections of the first storage medium 11 perpendicular to the current direction. For example, the first storage medium 11 is a trapezoidal body.

In this case, the first cross-sectional area corresponding to the maximum cross section of the first selector 12 is greater than the second cross-sectional area corresponding to the minimum cross section of the first storage medium 11, which indicates that an area of a part of the cross section of the first selector 12 perpendicular to the current direction is also increased. In this way, under a voltage provided by a bit line 15 and a word line 16 that are coupled to the first storage unit 1 shown in FIG. 2, because the cross section of the first selector 12 perpendicular to the current direction becomes larger, current flowing into the first selector 12 is increased. Because the first storage medium 11 and the first selector 12 are connected in series, current flowing into the first storage medium 11 is also increased, and a current density in the first storage medium 11 is also increased accordingly.

It can be learned that in the storage chip provided in this application, the current density in the resistive random-access memory may be increased by increasing a cross section of the selector perpendicular to the current direction without changing materials of the resistive random-access memory and the selector. Therefore, by using the storage chip provided in this application, some resistive random-access memories and selectors that originally cannot reach a corresponding current density when used in combination can reach a corresponding current density. In addition, by using the storage chip provided in this application, a limitation of the matching condition on selection of materials of the resistive random-access memory and the selector can be reduced to some extent. This enables resistive random-access memories and selectors of more materials to be used in storage chips.

In a possible implementation, the first storage unit 1 further includes a second electrode 14, the second electrode 14 is in contact with a second surface of the first selector 12, and the maximum cross section of the first selector 12 perpendicular to the current direction is the second surface of the first selector 12. The second electrode 14 is in contact with the second surface of the first selector 12, the second electrode 14 is connected to the word line or the bit line, and the first selector 12 is electrically connected to the bit line 16 through the second electrode 14.

The second surface of the first selector 12 is the maximum cross section of the first selector 12, that is, the maximum cross section of the first selector 12 is the surface in contact with the second electrode 14. In this case, because current passing through a unit cross section of the first selector is constant, through increasing the contact surface between the first selector 12 and the second electrode, more current can be supported to flow into the first storage unit 1. Therefore, the first storage medium 11 can obtain a larger current density.

In a possible implementation, a third cross-sectional area corresponding to a minimum cross section of the first selector 12 perpendicular to the current direction is greater than or equal to the second cross-sectional area.

The third cross-sectional area corresponding to the minimum cross section of the first selector 12 perpendicular to the current direction (or referred to as the minimum cross section of the first selector 12 subsequently) is greater than or equal to the second cross-sectional area corresponding to the minimum cross section of the first storage medium 11. In this case, an average cross-sectional area of cross sections of the second selector 12 perpendicular to the current direction is greater than an average cross-sectional area of cross sections of the first storage medium 11 perpendicular to the current direction. In this way, compared with the solution in the conventional technology that cross sections of the first storage medium 11 and the second selector 12 perpendicular to the current direction are the same, this application increases the cross-sectional area of the cross section of the first selector 12 perpendicular to the current direction, so that more current can flow into the first selector 12. Because the first storage medium 11 and the first selector 12 are connected in series, the current flowing into the first storage medium 11 is also increased, and the current density in the first storage medium 11 is also increased accordingly.

In a possible implementation, the minimum cross section of the first selector 12 perpendicular to the current direction is the first surface of the first selector 12.

Still refer to FIG. 2. In the cross sections of the first selector 12 perpendicular to the current direction, the minimum cross section is a top surface (the first surface) of the first selector 12, that is, a connection surface with the first electrode 13, and the maximum cross section is a bottom surface (the second surface) of the first selector, that is, a connection surface with the second electrode 14. In this way, the first selector 12 can be formed in a shape of a small top and a large bottom that is convenient for processing. This may facilitate processing of the first selector 12. In addition, to further facilitate processing of the storage chip, the minimum cross section of the first selector 12 perpendicular to the current direction has an area and a shape that are the same as those of a cross section of the first electrode 13 perpendicular to the current direction and the cross section of the first storage medium 11 perpendicular to the current direction. The maximum cross section of the first selector 12 perpendicular to the current direction has an area and a shape that are the same as those of a cross section of the second electrode 14 perpendicular to the current direction. For example, when the first storage medium is a cuboid, the minimum cross section of the first selector 12 perpendicular to the current direction may be equal to the cross sections of the first storage medium and the first electrode 13 perpendicular to the current direction. In addition, the cross section of the second electrode 14 perpendicular to the current direction may be equal to the maximum cross section of the first selector 12 perpendicular to the current direction.

In a possible implementation, the first selector 12 is a hexahedron, the hexahedron includes two parallel trapezoidal surfaces and two parallel rectangular surfaces, and the first surface and the second surface that are of the first selector 12 are respectively the two parallel rectangular surfaces of the hexahedron. The two parallel rectangular surfaces may be the minimum cross section and the maximum cross section that are of the first selector 12 perpendicular to the current direction respectively. In another possible implementation, the first selector 12 is a trapezoidal body, and the first surface and the second surface that are of the first selector 12 are respectively two parallel rectangular surfaces of the trapezoidal body. In addition, the two parallel rectangular surfaces of the first selector 12 may also be the minimum cross section and the maximum cross section that are of the first selector 12 perpendicular to the current direction respectively.

FIG. 2 shows only a structure in which a two-dimensional storage chip includes one layer of storage array. When a storage chip is a three-dimensional storage chip, a schematic diagram of a structure of the three-dimensional storage chip may refer to FIG. 3. The three-dimensional storage chip may include multiple layers of storage arrays (where only two layers of storage arrays are illustrated in FIG. 3). A structure and a connection relationship that are of each layer of storage array are consistent with a structure and a connection relationship that are of the storage units in FIG. 2, and details are not described herein again.

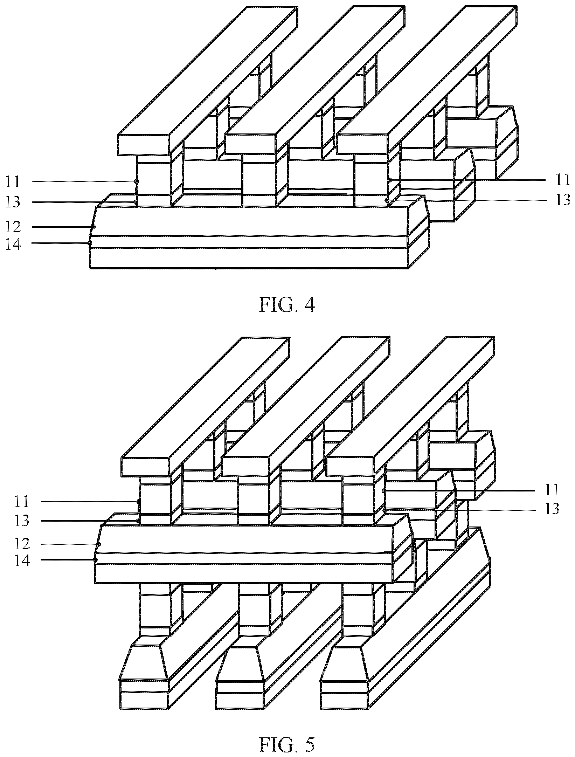

FIG. 4 is a diagram of a structure of a storage chip according to an embodiment of this application. The storage chip may be a two-dimensional storage chip.

Refer to FIG. 4. The two-dimensional storage chip includes one storage array, and first selectors 12 of first storage units 1 located in a same row or column are integrally formed. That is, in the storage chip shown in FIG. 4, for a plurality of first selectors 12 respectively corresponding to the first storage units 1 located in the same row or column, during processing, the plurality of first selectors 12 may be processed into one first selector 12 with a large size, and first storage media 11 located in the same row or column may share the one first selector 12. In this way, after one first storage medium 11 performs an operation such as read or write, heat generated by the first storage medium 11 and heat at a position where the first selector 12 and the first storage medium 11 contacts can be rapidly diffused to another part of the first selector 12. This is conductive to heat dissipation of the storage chip.

FIG. 4 is only a schematic diagram of the structure of the corresponding two-dimensional storage chip when the plurality of first storage media 11 share the same first selector 12. When the plurality of first storage media 11 share the same first selector 12, a schematic diagram of a structure of a corresponding three-dimensional storage chip may refer to FIG. 5.

A plurality of first storage units 1 included in the three-dimensional storage chip form a three-dimensional storage array, and the three-dimensional storage array includes multiple layers of storage arrays. At each layer of storage array, first selectors 12 of the first storage units 1 located in a same row or column are integrally formed.

In addition, to facilitate processing of the three-dimensional storage chip, first selectors 12 connected to a same word line or bit line through a second electrode 14 may be determined as the plurality of first selectors 12 to be integrally formed. In addition, a plurality of second electrodes 14 in contact with second surfaces of the first selectors 12 that are integrally formed may also be integrally formed.

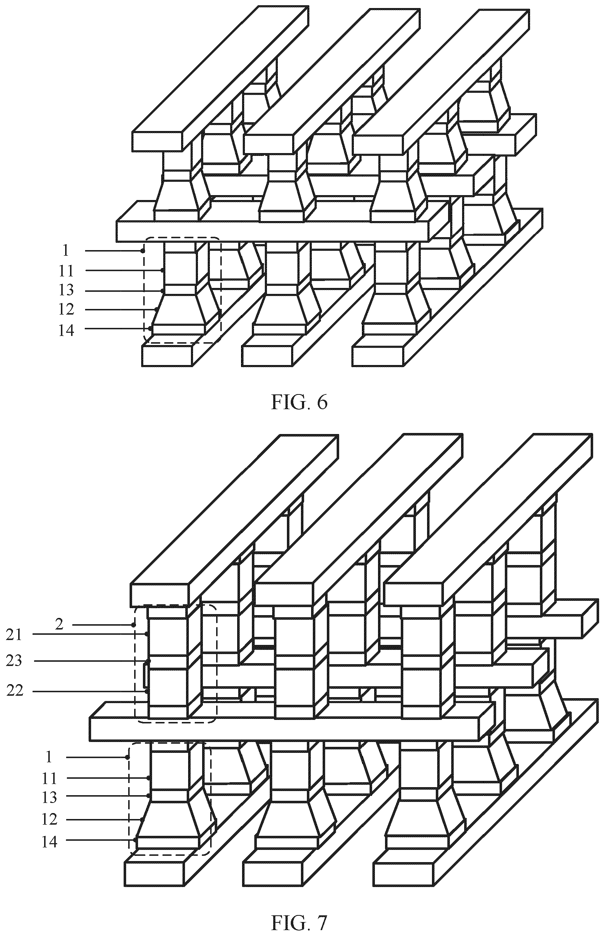

FIG. 6 is a schematic diagram of a structure of a storage chip according to an embodiment of this application.

In the storage chip shown in FIG. 6, a plurality of first storage units 1 form a three-dimensional storage array, and the three-dimensional storage array includes multiple layers of storage arrays. For two adjacent layers of the multiple layers of storage arrays, an average cross-sectional area of cross sections of a first selector 12 perpendicular to the current direction at one layer of storage array is greater than an average cross-sectional area of cross sections of a first selector 12 perpendicular to the current direction at the other layer of storage array. A first storage medium in the storage chip shown in FIG. 6 may be a phase change memory.

When current directions in phase change memories are different, the phase change memories may have temperature rise or temperature fall characteristics respectively. When a temperature changes, a current density required for performing an operation such as read, write, or erase on the phase change memory changes. In the three-dimensional storage chip, because a current direction between a bit line and a word line is determined, and storage units at the two adjacent layers in the three-dimensional storage chip share a same group of bit lines or word lines, current directions corresponding to the storage units at the two adjacent layers are opposite. In this case, in the storage units at the two adjacent layers, a temperature of a phase change memory at one layer is increased due to the current direction, and a required current density is decreased; and a temperature of a phase change memory at the other layer is decreased due to the current direction, and a required current density is increased.

Therefore, in FIG. 6, for the two adjacent layers of storage arrays, for the layer at which the temperature of the phase change memory is decreased due to the current direction, the average cross-sectional area of the cross sections of the first selector 12 perpendicular to the current direction at this layer may be set to be greater than the average cross-sectional area of the cross sections of the first selector 12 perpendicular to the current direction at the other layer. In this way, a current density of the phase change memory at one layer may be increased, thereby resolving a problem caused by a temperature decrease, to provide an increased current density required by the phase change memory. In addition, at the other layer, although a current density of the phase change memory is relatively low, the temperature of the phase change memory is increased. Therefore, the relatively low current density can still satisfy a current density required for performing an operation such as read, write, or erase on the phase change memory.

For a shape corresponding to the first selector 12 at any layer shown in FIG. 6, refer to the descriptions of the first selector 12 in the foregoing embodiments. For example, the first selector 12 may be a hexahedron or a trapezoidal body. In addition, in the storage chip shown in FIG. 6, at each layer of storage array, the first selectors 12 of the first storage units 1 located in a same row or column are integrally formed.

FIG. 7 is a schematic diagram of a structure of a storage chip according to an embodiment of this application. The storage chip shown in FIG. 7 further includes a plurality of second storage units 2, a plurality of first storage units 1 and the plurality of second storage units 2 form a three-dimensional storage array, and the three-dimensional storage array includes multiple layers of storage arrays. Each second storage unit 2 includes a second storage medium 21, a second selector 22, and a third electrode 23. The second storage medium 21 is in contact with a first surface of the third electrode 23, the second selector 22 is in contact with a second surface of the third electrode 23, and the first surface and the second surface that are of the first electrode are two opposite surfaces. Any cross section of the second selector 22 perpendicular to a current direction is equal to any cross section of the second storage medium 21 perpendicular to the current direction. The plurality of first storage units 1 and the plurality of second storage units 2 are respectively located in two adjacent layers of the multiple layers of storage arrays.

In addition, it should be noted that an average cross-sectional area of cross sections of the first selector 12 perpendicular to the current direction is greater than an average cross-sectional area of cross sections of the second selector 22. The second storage unit 2 may be a storage unit in the conventional technology.

Same as FIG. 7, because when directions of current flowing into phase change memories are different, the phase change memories may respectively have temperature rise or temperature fall characteristics. When a temperature changes, a current density required for performing an operation such as read, write, or erase on the phase change memory changes. Therefore, in the storage chip shown in FIG. 7, in the two adjacent layers of storage arrays, one layer of storage array is formed by the first storage units 1, and the other layer of storage array is formed by the second storage units 2. The layer at which the temperature of the phase change memory is decreased due to the current direction may be formed by the first storage units. In this way, a current density of a first storage medium 11 at this layer may be increased, thereby resolving a problem caused by a temperature decrease, to provide an increased current density required by the phase change memory.

For a shape corresponding to the first selector 12 shown in FIG. 7, refer to the descriptions of the first selector 12 in the foregoing embodiments. For example, the first selector 12 may be a hexahedron or a trapezoidal body. In addition, in the storage chip shown in FIG. 7, in the storage array formed by the first storage units 1, the first selectors 12 of the first storage units 1 located in a same row or column are integrally formed. Similarly, in the storage array formed by the second storage units 2, the second selectors 22 of the second storage units 2 located in a same row or column may also be integrally formed.

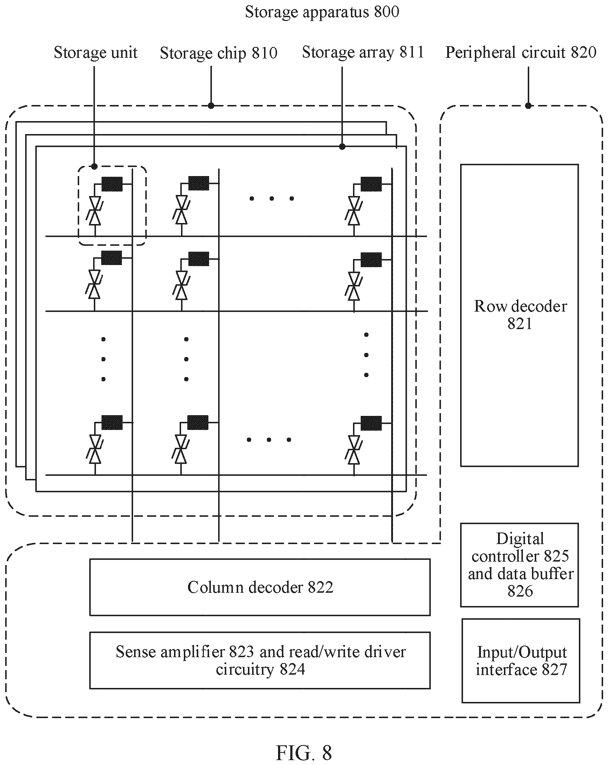

FIG. 8 shows a storage apparatus provided in this application. Refer to FIG. 8. The storage apparatus 800 may include a storage chip 810 and a peripheral circuit 820. The peripheral circuit 820 is electrically connected to the storage chip 810, and the peripheral circuit 820 controls data reading and writing in the storage chip.

The storage chip 810 includes one or more layers of storage arrays 811. The storage chip 810 may be the storage chip described in the foregoing embodiments, and details may refer to the foregoing embodiments.

The peripheral circuit 820 includes: a row decoder (Row Decoder) 821, a column decoder (Column Decoder) 822, a sense amplifier (Sense Amplifier) 823, a read/write driver circuitry (Driver Circuitry) 824, a digital controller (Digital Controller) 825, a data buffer (Data buffer) 826, and an input/output interface (I/O Interface) 827. The row decoder 821 is connected to a word line of the storage array in the storage chip 810, and the column decoder 822 is connected to a bit line of the storage array in the storage chip 810. Data read by the sense amplifier 823 and the read/write driver circuitry 824 and data to be written into the storage array are stored in the data buffer 826, the digital controller 825 finally controls all the foregoing circuits to complete a corresponding operation such as read or write, and data and command exchange with another external system may be completed through the input/output interface 827.

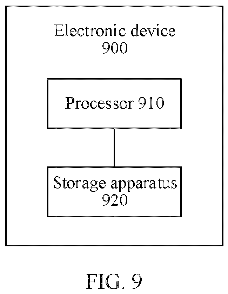

FIG. 9 shows an electronic device provided in this application. Refer to FIG. 9. The electronic device 900 includes a processor 910 and a storage apparatus 920. The storage apparatus 920 may be the storage apparatus shown in FIG. 9. The processor may be a central processing unit (central processing unit, CPU). The processor 910 is configured to read data from or write data into the storage apparatus 920.

In this application, terms such as "first" and "second" are used to distinguish between same items or similar items that have basically same functions. It should be understood that there is no logical or time sequence dependency between "first" and "second", and a quantity and an execution sequence are not limited. It should also be understood that although the following description uses terms such as "first" and "second" to describe various elements, these elements should not be limited by the terms. These terms are merely used to distinguish one element from another. For example, without departing from the scope of the various examples, the first storage unit may be referred to as the second storage unit, and similarly, the second storage unit may be referred to as the first storage unit. Both the first storage unit and the second storage unit may be referred to as a storage unit, and in some cases, may be separate and different storage units.

In this application, the term "at least one" means one or more and the term "a plurality of" means two or more.

The foregoing descriptions are merely specific implementations of this application, but are not intended to limit the protection scope of this application. Any equivalent modification or replacement readily figured out by a person skilled in the art within the technical scope disclosed in this application shall fall within the protection scope of this application. Therefore, the protection scope of this application shall be subject to the protection scope of the claims.

## Claims

1. A storage chip, wherein the storage chip comprises a plurality of first storage units (1), and each first storage unit (1) comprises a first storage medium (11), a first selector (12), and a first electrode (13);
the first storage medium (11) is in contact with a first surface of the first electrode (13); and a first surface of the first selector (12) is in contact with a second surface of the first electrode (13), and the first surface and the second surface that are of the first electrode are two opposite surfaces, wherein
a first cross-sectional area corresponding to a maximum cross section of the first selector (12) perpendicular to a current direction is greater than a second cross-sectional area corresponding to a minimum cross section of the first storage medium (11) perpendicular to the current direction.

2. The storage chip according to claim 1, wherein the first storage unit (1) further comprises a second electrode (14), the second electrode (14) is in contact with a second surface of the first selector (12), and the maximum cross section of the first selector (12) perpendicular to the current direction is the second surface of the first selector (12).

3. The storage chip according to claim 2, wherein a third cross-sectional area corresponding to a minimum cross section of the first selector (12) perpendicular to the current direction is greater than or equal to the second cross-sectional area.

4. The storage chip according to claim 3, wherein the minimum cross section of the first selector (12) perpendicular to the current direction is the first surface of the first selector (12).

5. The storage chip according to any one of claims 2 to 4, wherein the first selector (12) is a hexahedron, and the hexahedron comprises two parallel trapezoidal surfaces and two parallel rectangular surfaces, wherein the first surface and the second surface that are of the first selector (12) are respectively the two parallel rectangular surfaces of the hexahedron.

6. The storage chip according to any one of claims 2 to 4, wherein the first selector (12) is a trapezoidal body, and the first surface and the second surface that are of the first selector (12) are respectively two parallel rectangular surfaces of the trapezoidal body.

7. The storage chip according to any one of claims 1 to 6, wherein the plurality of first storage units (1) form a three-dimensional storage array, and the three-dimensional storage array comprises multiple layers of storage arrays, wherein
in at least one layer of storage array, first selectors (12) of the first storage units (1) located in a same row or column are integrally formed.

8. The storage chip according to any one of claims 1 to 6, wherein the plurality of first storage units (1) form a three-dimensional storage array, and the three-dimensional storage array comprises multiple layers of storage arrays, wherein
for two adjacent layers of the multiple layers of storage arrays, an average cross-sectional area of cross sections of a first selector (12) perpendicular to the current direction at one layer of storage array is greater than an average cross-sectional area of cross sections of a first selector (12) perpendicular to the current direction at the other layer of storage array.

9. The storage chip according to any one of claims 1 to 6, wherein the storage chip further comprises a plurality of second storage units (2), the plurality of first storage units (1) and the plurality of second storage units (2) form a three-dimensional storage array, and the three-dimensional storage array comprises multiple layers of storage arrays, wherein
each second storage unit (2) comprises a second storage medium (21), a second selector (22), and a third electrode (23);
the second storage medium (21) is in contact with a first surface of the third electrode (23), the second selector (22) is in contact with a second surface of the third electrode (23), the first surface and the second surface that are of the third electrode are two opposite surfaces, and any cross section of the second selector (22) perpendicular to the current direction is the same as any cross section of the second storage medium (21) perpendicular to the current direction; and
the plurality of first storage units (1) and the plurality of second storage units (2) are respectively located in two adjacent layers of the multiple layers of storage arrays.

10. The storage chip according to any one of claims 1 to 9, wherein the first storage medium (11) is a resistive random-access memory.

11. A storage apparatus, wherein the storage apparatus comprises a peripheral circuit and at least one storage chip according to any one of claims 1 to 10, and the peripheral circuit is configured to read data from or write data into the at least one storage chip.

12. An electronic device, wherein the electronic device comprises a processor and the storage apparatus according to claim 11, and the processor is configured to read data from or write data into the storage apparatus.
